# EUROPEAN PATENT APPLICATION

(11) **EP 4 636 991 A1**
(43) Date of publication of application: **22.10.2025**
(21) Application number: 24170350.3
(22) Date of filing: 15.04.2024
(51) Int. Cl.: H02J 50/30, H02J 50/40, F17C 3/08

(54) **A METHOD AND A SYSTEM FOR PROVIDING ELECTRICAL ENERGY TO A COOLING STAGE OF A CRYOSTAT SYSTEM**

(71) Applicant: Winse Power Oy, 33720 Tampere (FI)
(72) Inventor: AHO, Arto, 33870 Tampere (FI); HAKKARAINEN, Teemu, 33800 Tampere (FI); NIKANDER, Veikka, 33100 Tampere (FI); POLOJÄRVI, Ville, 33710 Tampere (FI)
(74) Representative: WSL Patentanwälte Partnerschaft mbB

(57) **Abstract**

The present invention relates to a method for providing electrical energy to an electronic circuitry located in a first cooling stage of a cryostat system operated at a first cooling temperature, wherein the first cooling temperature is smaller than 273 K, wherein the method comprises the steps: generating and emitting powering electromagnetic radiation at a location outside the first cooling stage; illuminating a photovoltaic power converter with the powering electromagnetic radiation, wherein the photovoltaic power converter is located in the first cooling stage, and wherein the electronic circuitry is electrically connected to the photovoltaic power converter; generating an electric current in the photovoltaic power converter; and electrically powering or biasing the electronic circuitry. There is a need for a method for providing electrical energy to an electronic circuitry located in the first cooling stage of a cryostat system. In order to address this object the method according to the present invention further comprises the step of transmitting excess energy introduced into the first cooling stage by the powering electromagnetic radiation out of the first cooling stage by means at least of dissipating electromagnetic radiation or of the electric current.

## Description

The present invention relates to a method for providing electrical energy at least to an electronic circuitry located in a first cooling stage of a cryostat system operated out of first cooling temperature. The first cooling temperature is below 273 K. The method comprises the steps of: generating emitting powering electromagnetic radiation at a location outside the first cooling stage, illuminating a photovoltaic power converter with the powering electromagnetic radiation, wherein the photovoltaic power converter is located in the first cooling stage, and wherein the electronic circuitry is electrically connected to the photovoltaic power converter, generating and electric current in the photovoltaic power converter, and electrically powering or biasing the electronic circuitry.

The present invention also relates to a cryostat system comprising a first cooling stage to be operated at a first cooling temperature, wherein the first cooling temperature is smaller than 273 K, an electronic circuitry, a photovoltaic power converter located in the first cooling stage, and a radiation source located outside the first cooling stage, wherein the radiation source is arranged and located such that during use of the cryostat system powering electromagnetic radiation is emitted by the radiation source and illuminates the photovoltaic power converter, wherein the electronic circuitry is electrically connected to the photovoltaic power converter such that during operation of the cryostat system the photovoltaic power converter powers or biases the electronic circuitry.

Cryogenic applications of electronic circuitry typically require conductive wiring, which in turn requires feedthrough interfaces in a thermally insulating structure of the cryostat compromising the thermal insulation efficiency of the cryostat. Once metal wires are used in existing solutions heat is transferred into the cooling stage or a plurality of cooling stages of the cryostat system, which might operate at low temperatures down to a range of a few Kelvin. Heat is transferred into the cryostat from the surrounding ambient conditions (roomtemperature). Heat transfer has in particular proven to be problematic in case of coaxial cables, wherein the electrical isolation of the center conductor also acts as a heat insulation providing efficient guiding of heat through the center conductor from ambient conditions to the cooling stage(s). Such coaxial electrical wires require use of e.g. 0 dB attenuators at each cooling stage for thermalizing the electrical conductors increasing the complexity of the cryostat system. This reduces the overall efficiency of the cryostat system and forces to use large and powerful cryogenic refrigerators leading to increased cost and complexity.

This becomes particularly significant for cryogenic systems, wherein the number of electronic and optoelectronic elements at the cooling stage(s) is scaled up, e.g. in quantum computers. Once the number of electronic and optoelectronic elements at the cooling stage is increased the number of interfaces providing either powering, biasing or signaling increases as well. In these cases, the minimum cooling power required for the cryostat system is determined by the number of interfaces rather than by the low-temperature to be reached in the system.

Thus, in the prior art methods for providing electrical energy to an electronic circuitry in a cryostat have been reported, wherein transfer of energy from an ambient environment to the cooling stage is not provided by electrically conductive wiring, but by means of photons.

However, it has turned out that depending on the application and thus on the elements to be powered or biased excess energy might be introduced into the respective cooling stage. This excess energy which at least at a specific point in time cannot be used by any elements at the cooling stage and thus only contributes to a reduction of the overall cooling efficiency of the cryogenic system.

Consequently, there is a need for a method for providing electrical energy to an electronic circuitry located in the first cooling stage of a cryostat system. Furthermore, there is a need for a cryostat system enabling a more efficient provision of temperatures below ambient temperature.

At least one of the above objects is solved by a method according to the present invention as defined in appended independent claim 1. Therefore, the method as defined above further comprises the step of transmitting excess energy introduced into the first cooling stage by the powering electromagnetic radiation out of the first cooling stage by means at least of dissipating electromagnetic radiation or of the electric current.

At least one of the above objects is also solved by cryostat system according to the attached independent claim 7. Therefore, according to the present invention the cryostat system as described above comprises a transmitting element, wherein the transmitting element is electrically connected to the photovoltaic power converter or is the photovoltaic power converter, wherein the transmitting element is arranged such that the transmitting element during operation of the cryostat system transmits excessive energy introduced into the first stage by the powering electromagnetic radiation out of the first stage by means of dissipating electromagnetic radiation or of the electric current.

It is the basic concept of the present invention to transmit excess energy introduced into the first cooling stage by the powering electromagnetic radiation out of first cooling stage using either electromagnetic radiation, i.e. by means of photos, or using the electric current generated by the photovoltaic power converter in the first cooling stage.

Transfer of energy to power or bias an electronic circuitry according to the present invention is carried out by generating powering electromagnetic radiation in a radiation source outside the first cooling stage. Then the generated electromagnetic radiation is guided into the first cooling stage, wherein this guidance either is established free space using transparent windows in the insolating structure of the cryostat system or by fiber coupling. Fiber coupling is advantageous as it reduces the heat load introduced into the system. Optical fibers have a much higher thermal resistance than electrically conductive wirings.

A photovoltaic power converter (PVC) is a structure converting electromagnetic radiation emitted by a man-made electromagnetic radiation source into electric energy. The combination of a man-made electromagnetic radiation source and a photovoltaic power converter is also denoted as a power-by-light system. Power-by-light systems are used to transfer energy to remote devices not being connected to an electricity grid. In an embodiment, the photovoltaic power converter is optimized for a single narrowband or plurality of narrowbands of optical energy transfer. In contrast, solar cell structures are designed to provide high efficiency over an as broad as possible spectrum matching the white electromagnetic spectrum of the sun. In a further embodiment, the electromagnetic radiation source of the power-by-light-system is arranged to emit the powering electromagnetic radiation having a wavelength spectrum with a full width half maximum of 100 nm or less, preferably of 50 nm or less, of 10 nm or less or of 5 nm or less. In an embodiment, the photovoltaic power converter is optimized to generate the electric current when illuminated by the powering electromagnetic radiation having a wavelength spectrum with a full width half maximum of 100 nm or less, preferably of 50 nm or less, of 10 nm or less or of 5 nm or less.

Photovoltaic converters typically are power sources. Photodiodes in contrast to photovoltaic power converters are designed to sense electromagnetic radiation by producing photo generated current. Photovoltaic power converters are distinct from photodiodes by operation. Photovoltaic power converters are operated in the 4^{th} quadrant of the current-voltage relation, whereas photodiodes typically operate in the 3^{rd} quadrant of the current-voltage relation. 4^{th} quadrant of the current-voltage relation is defined as the component having positive voltage and negative current resulting in negative power, which means in the context of electronics, power generation from the device to an external circuit. 3^{rd} quadrant of the current-voltage relation is defined as the component having negative voltage and negative current, resulting in positive power, which means in the context of electronics, power consumption by the device from the external circuit.

The key parameters for optimization of PVCs are the output power of the device as well as the power density of the device. Higher output power enables wider use cases for the power-by-light technology and higher power density enables smaller footprints which in turn promotes device miniaturization and decrease of manufacturing costs. In an embodiment, the PVC comprises a multijunction structure. A PVC with such stacked junctions is called a multijunction design, multiplying the output voltage of a single junction by the number of junctions in the stack.

Thus, in an embodiment of the present invention the cryostat system also includes a source for powering electromagnetic radiation, i.e. the system comprises the entire power-by-light system. In an embodiment of the present invention the source for the powering electromagnetic radiation is a laser, in particular a laser diode, or a light emitting diode.

According to a particular embodiment of the present invention the radiation source is located not only outside the first cooling stage, but in an ambient environment outside an insulating structure of the cryostat system.

In the present application the term powering electromagnetic radiation denotes the electromagnetic radiation generated outside the first cooling stage and transmitted into the first cooling stage in order to illuminate the photovoltaic power converter. In contrast electromagnetic radiation transmitting excess energy out of the first cooling stage is referred to as dissipating electromagnetic radiation in the present application.

The cryostat system according to the present invention comprises at least one cooling stage denoted the first cooling stage. This first cooling stage is at a temperature below 273 K, i.e. well below room temperature.

In an embodiment of the present invention, the first cooling stage has a first cooling temperature of 175 K or less, preferably of 77 K or less or of 4.5 K or less. In an embodiment, the first cooling stage has a first cooling temperature of 1.5 K or less. At 1.5 K typically, a superconducting electronic circuitry is operable.

In an embodiment of the present invention the cryostat system comprises a plurality of cooling stages, namely at least the first cooling stage and a second cooling stage, wherein all of the cooling stages are at temperatures well below room temperatures, in particular the first and second cooling temperatures are smaller than 273 K. In an embodiment, the second cooling stage has a second cooling temperature smaller than 273 K and larger than the first cooling temperature.

In an embodiment of the present invention, the cryostat system comprises a second cooling stage at a second cooling temperature, wherein the second cooling temperature is smaller than 273 K and is larger than the first cooling temperature, and wherein the photovoltaic power converter is located in the first cooling stage and the transmitting element is located in the second cooling stage.

In a further embodiment the cryostat system comprises a third cooling stage at a third cooling temperature, wherein the third cooling temperature is smaller than the first cooling temperature. In an embodiment the electronic circuitry is located in the third cooling stage. Optionally, the third cooling stage has a third cooling temperature at 1.5 K.

In a further embodiment the electronic circuitry is located at the third cooling stage at a third cooling temperature, wherein this third cooling temperature is smaller than the first cooling temperature. In an embodiment, an electrical wiring between the photovoltaic power converter in the first cooling stage and the electronic circuitry in the third cooling stage is provided by superconducting wires.

The plurality of cooling stages of the cryostat system in an embodiment are arranged in series.

In an embodiment of the present invention, the step of transmitting the excess energy comprises generating the dissipating electromagnetic radiation in a light emitting element driven by the electric current generated in the photovoltaic power converter, and transmitting the dissipating electromagnetic radiation to a location outside the first cooling stage. Thus, in an embodiment of the cryostat system the transmitting element is a light emitting element converting the electrical current into the dissipating electromagnetic radiation during operation of the cryostat system. Preferably, the light emitting element is a laser diode or a light emitting diode (LED).

The transmitting element of the cryostat system according to an embodiment of the present invention light is arranged such that the transmitting element during operation of the cryostat system transmits excessive energy as dissipating electromagnetic radiation, wherein the cryostat system comprises means for guiding the dissipating electromagnetic radiation out of the first cooling stage.

This means is for example a window or an electromagnetic waveguide for the dissipating electromagnetic radiation, e.g. an optical fiber.

In an embodiment of the present invention, at least the photovoltaic power converter or the light emitting element are coupled by an electromagnetic wave guide, e.g. an optical fiber.

In an embodiment of present invention, the photovoltaic power converter and the light emitting element are coupled to single electromagnetic waveguide, in particular to a single optical fiber.

In this embodiment the cryostat system comprises a light emitting element, e.g. a semiconductor laser, a laser diode or light emitting diode, for generating photon transmitting the excess energy out of the first cooling stage.

In an embodiment of the present, invention the light emitting element is located in the first cooling stage. However, an embodiment is feasible, wherein the light emitting element is located in the cryostat, but outside the first cooling stage. In an embodiment, the light emitting element is located in a second cooling stage, wherein the second cooling stage is at a second cooling temperature, and wherein the second cooling temperature is larger than the first cooling temperature.

In the present application the terms first, second and third cooling stage are used in order to denote different cooling stages without stating any particular order of these cooling stages.

In an embodiment of the cryostat system the photovoltaic power converter comprises a plurality of active junctions, wherein an output voltage of the photovoltaic power converter is at least as large as a threshold voltage of the light emitting element.

In an embodiment of the cryostat system, the photovoltaic power converter comprises an operation point voltage of the PVC junction, and the light emitting element comprises an emitter threshold voltage, and wherein the emitter threshold voltage is equal to or smaller than the operation point voltage. Fulfilment of this condition helps to design the combination of the photovoltaic power converter and the light emitting element such that the photovoltaic power converter generates enough voltage to power the light emitting elements.

In an embodiment of the cryostat system, the photovoltaic power converter comprises a converter band gap and plurality of PVC junctions, and the light emitting element comprises an emitter threshold voltage, and wherein the emitter threshold voltage is smaller than the sum of the operation point voltages of the plurality of PVC junctions. Fulfilment of this condition helps to design the combination of the photovoltaic power converter and the light emitting element such that the photovoltaic power converter generates enough voltage to power the light emitting elements.

In a further embodiment of the cryostat system the light emitting element is connected in series or in parallel to the electronic circuitry. The series connection of the light emitting element is particularly favorable in the context of a superconducting electronic circuitry. During the operation, the light emitting element transmits the dissipating electromagnetic radiation during the superconducting state (low series resistance) and switches off during the resistive state (high series resistance) of the superconducting electronic circuitry. Advantage of the series connection used with the superconducting electronic circuitry is the effective transmission of the excess energy out of the first cooling state by transmitting the dissipating electromagnetic radiation. Benefit of the series connection is further increased if the superconducting electronic circuitry stays in the superconducting state during most of the operation time and recovers fast from the resistive state back to the superconducting state. In the parallel connection, where the superconducting electronic circuitry acts as a shunt resistor, the light emitting element is activated during the resistive state of the superconducting element. In the context of a superconducting electronic circuitry, the parallel connection is preferential if the superconducting electronic circuitry is operated in such way that it is in the resistive state during majority of the operation cycle and switches to the superconducting state only momentarily.

In an embodiment of the present invention, the photovoltaic power converter and the light emitting element are implemented in separate devices, i.e. two distinct chip assemblies. However, in an alternative embodiment of the present invention the photovoltaic power converter and the light emitting element are assembled in a single optoelectronic chip assembly.

In a further embodiment, transmitting the excess energy comprises guiding the electric current through an electrical resistor, wherein the electrical resistor is located outside the first cooling stage. The electrical resistor converts the excess current and thus the excess power into heat.

In an embodiment of the cryostat system, the transmitting element is arranged such that the transmitting element during operation of the cryostat system converts electrical energy into heat and is located outside the first cooling stage. In an embodiment, the energy transmitting element is an electrical resistor. In an embodiment, this electrical resistor is not emitting any light.

By placing the electrical resistor outside the first cooling stage dissipation of electric power by the electrical resistor does not account on the heat load of the first cooling stage. In an embodiment of the present invention the electrical resistor is located in the second cooling stage. Optionally the electrical resistor is not an optoelectronic device generating photons, in particular not generating dissipating electromagnetic radiation.

In the above embodiment the dissipating electromagnetic radiation is generated in a light emitting device and is then emitted to be transmitted to a location outside the first cooling stage. The current generated by the photovoltaic power converter in this option drives the light emitting device.

However, other possibilities to transmit the excess energy by photons are possible. Thus, according to a further embodiment of the present invention, the step of transmitting the excess energy comprises radiating the dissipating electromagnetic radiation from the photovoltaic power converter to a location outside the first cooling stage.

In an embodiment of the present invention the photovoltaic power converter is the transmitting element, wherein the photovoltaic power converter is arranged such that during operation of the cryostat system the photovoltaic power converter radiates the dissipating electromagnetic radiation to a location outside the first cooling stage.

In this embodiment, wherein the dissipating electromagnetic radiation is radiated from the photovoltaic power converter itself this radiation may be based on two schemes or a combination thereof:
- In an embodiment, the powering electromagnetic radiation illuminating the photovoltaic power converter is reflected by the photovoltaic power converter as far as the powering electromagnetic radiation is excess radiation which cannot contribute to the electric power generation. In an embodiment, the photovoltaic power converter comprises a reflector which in the transmission direction of the incoming powering electromagnetic radiation is placed behind the active layer of the photovoltaic power converter. Only light which hasn't been absorbed by the photovoltaic power converter is reflected. In a situation, wherein the photovoltaic power converter absorbs more of the powering electromagnetic radiation less electromagnetic radiation is reflected out of the first cooling stage and vice versa. In these embodiments, the electromagnetic radiation after the reflection is denoted the dissipating electromagnetic radiation.
- In an alternative embodiment, the dissipating electromagnetic radiation is generated in the photovoltaic power converter due to absorption of the powering electromagnetic radiation and reemission of photons of the dissipating electromagnetic radiation from the photovoltaic power converter.

In an embodiment of the present invention the dissipating electromagnetic radiation or the electric current at a location outside the first cooling stage are not only used to transfer the excess energy out of the first cooling stage, but also for signaling a state of the electronic circuitry. Thus, in an embodiment of the present invention the method also comprises the steps: detecting the dissipating electromagnetic radiation or the electric current at a location outside the first cooling stage, generating a detector signal representing a property of the dissipating electromagnetic radiation or the electric current, and determining a state of the electronic circuitry from the detector signal.

In a further embodiment of the present invention, the dissipating electromagnetic radiation or the electric current at a location outside the first cooling stage are not only used to transfer the excess energy out of the first cooling stage, but also for signaling a state of the cryostat system. In this embodiment the state of the cryostat system changes at least one property of the dissipating electromagnetic radiation or the electric current originating from the transmitting element.

The property of the dissipating electromagnetic radiation determining the state of the electronic circuitry or determining the state of the cryostat system is selected from a group comprising wavelength, polarization, slew rate, phase, pulse width, modulation frequency, and intensity or a combination thereof.

In an embodiment of the cryostat system, the cryostat system comprises a detector located outside the first cooling stage and a controller, wherein the controller is effectively connected to the detector such that during operation of the cryostat system the controller receives a detector signal from the detector, wherein the detector signal represents a property of the dissipating electromagnetic radiation detected by the detector, wherein the detector is arranged and located such that the detector during operation of the cryostat system detects the dissipating electromagnetic radiation emitted by the light emitting element, and where in the controller is set up to determine a state of the electronic circuitry from the detector signal.

In an embodiment of the present invention the electronic circuitry is a sensor or an actuator.

In a further embodiment of the present invention the sensor is a superconducting sensor or the actuator is a superconducting actuator. In a preferred embodiment the superconducting sensor is a superconducting nanowire single photon detector (SNSPD).

In a further embodiment of the present invention the electronic circuitry is part of a quantum computer.

Further the advantages, features and applications of the present invention will become apparent from the following description of embodiments and the corresponding figures attached. The foregoing as well as the following detailed description of the embodiments are better understood when read in conjunction with the appended figures. It should be understood that the embodiments depicted are not limited to the precise arrangements and instrumentalities shown. In the figures equal elements are denoted by identical reference numbers.
- Figure 1: is a schematic representation of a cryostat system according to the prior art.
- Figure 2: is a schematic representation of a cryostat system according to a first embodiment of present invention.
- Figure 3: is a schematic representation of a cryostat system according to a second embodiment of present invention.
- Figure 4: is a schematic representation of a cryostat system according to a further embodiment of present invention.

The basic concepts of the present invention are illustrated with reference to the Figures assuming that a superconducting nanowire single-photon detector (SNSPD) 2 shall be powered and read out. The SNSPD 2 forms an example of an electronic circuitry according to the present invention. In order to exhibit its superconducting properties, the SNSPD 2 must be cooled down to an operating temperature which is chosen based on the superconducting material of the SNSPD 2 so that the detector is maintained well below the critical temperature. Therefore, the SNSPD 2 is part of a cryostat system 1. In the illustrative examples the SNSPD 2 is placed in a cryostat comprising a first cooling stage 3 at a first cooling temperature of 3.5 K.

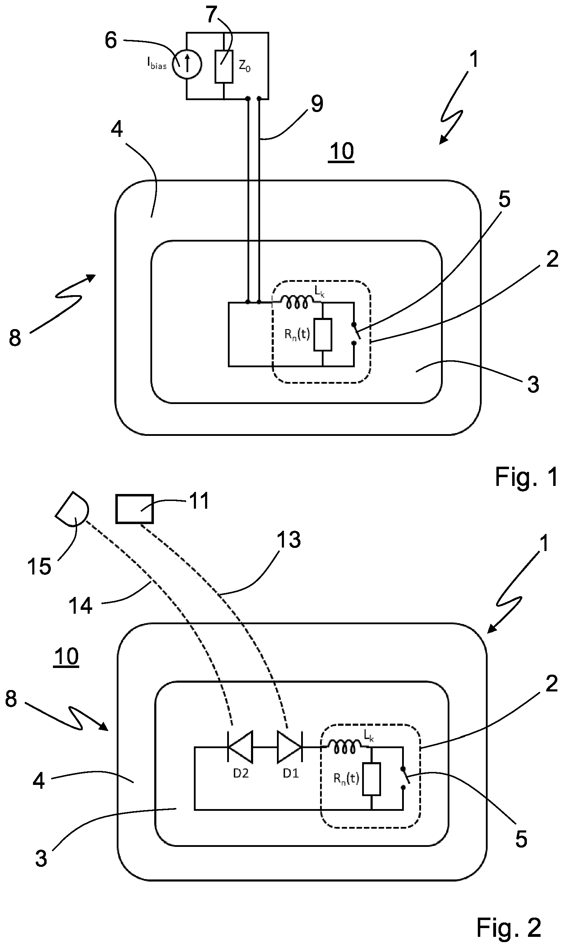

The SNSPD 2 in Figures 1, 2 and 4 is presented by an equivalent circuit consisting of a kinetic inductance Lₖ, hotspot resistance Rₙ, and a switch 5 which simulates absorption of a photon. The open and closed states of the switch 5 correspond to a resistive state on the one hand (photon absorbed) and superconductive state (no photon absorbed). In the prior art schematically depicted in Figure 1 an interface for the external biasing and readout consists of an external DC current source 6 and a load impedance 7 which are located outside the cryostat 8. Such electrical biasing and readout require an RF cable pair 9 for each detector channel. The copper cables of the cable pair have to be thermalized at each cooling stage 3, 4, e.g. by 0 dB attenuators, in order to avoid direct thermal contact between the respective first and second cooling stages 3, 4 and the ambient environment 10 via the cable pair 9. This increases the complexity of the cryostat system in a way which scales with the number of SNSPDs 2 required in a specific application. It is also important to note, that the thermal load leaking from room temperature to the low temperature stage increases with the number of SNSPDs 2 regardless of the level of Joule heating in the first cooling stage.

In the applications described with reference to the Figures the photons detected by the SNSPD 2 are generated by other elements in the cryogenic environment, e.g. in the first cooling stage.

The SNSPD 2 applied in the prior art design described above with reference to Figure 1 as well as applied in the embodiments according to the present invention according to Figures 2 to 4 is known from the prior art. In summary operation of the SNSPD 2 can be described as follows. The SNSPD 2 is biased with a DC current which is close to the critical current that would cause quenching to resistive state. A small resistive hotspot is created by absorption of a single photon. The local current density of the supercurrent exceeds the critical value due to the small cross-sectional area of the nanowire. Consequently, a resistive barrier is formed across the entire cross section of the nanowire. Resistive heating leads to the growth of the resistive barrier along the axial direction of the nanowire. In the prior at, at this point the bias current is shunted by the external readout circuitry 6, 7, which allows the nanowire to recover to the superconducting state.

In order to avoid direct thermal contact between the respective first and second cooling stages 3, 4 and the ambient environment 10 according to the present invention as described with reference to Figures 2 to 4 replaces the external biasing 6, 7 and the interfacing cable pair 9 by a laser 11 as a light emitting element in the ambient environment 10 and a photovoltaic power converter (PVC) D1 in the first cooling stage 3. The Laser 11 and the photovoltaic power converter D1 are coupled by a waveguide for electromagnetic radiation, namely an optical fiber 13. The laser radiation emitted by the laser 11 and coupled into the optical fiber 13 is denoted powering electromagnetic radiation as it powers the supercurrent through the SNSPD 2 and thus the SNSPD 2.

Use of the PVC D1 drastically reduced the heat losses of the first and second cooling stages 3, 4 brought along by the cable pair 9 of the prior art. In contrast to an electrically conducting wire an optical fiber has a far higher thermal resistance.

The embodiment of Figure 2 is optimized for powering the SNSPD 2 where controllable bias current and no high voltages are required. However, the SNSPD 2 has nearly zero resistance in its superconducting state.

The embodiment of Figure 2 uses an external load for maximizing the conversion efficiency of the PVC D1. This load is a light emitting diode (LED) denoted as D2 in Figure 2. The optical power generated and emitted by the LED D2 is transferred to the ambient environment 10 using an optical fiber 14. This explains why the LED D2 in the present application is also referred to as the transferring element. The electromagnetic radiation generated by the LED D2 is referred to as the dissipating electromagnetic radiation as it dissipated heat load from the first cooling stage 3. Part of the excess energy transported into the first cooling stage 3 by the powering electromagnetic radiation will be exported as light from the cryostat 8 and is and not converted into heat.

The LED D2 and the PVC D1 are connected in series. Consequently, an intensity of the dissipating electromagnetic radiation emitted by the LED D2 reflects the state of the PVC D1 device. The intensity of the dissipating electromagnetic radiation emitted by the LED D2 is dependent on the operation current and voltage of the PVC D1. Since the SNSPD 2 is in the same circuit as the LED D2 and PVD D1 the state of the SNSPD 2 is also reflected by the intensity of the dissipating electromagnetic radiation emitted by the LED D2.

Consequently, the dissipating electromagnetic radiation emitted by the LED D2 and guided through the optical fiber 14 is detected by a photodiode 15 at the ambient environment 10. The intensity detected by the photodiode 15 indicates the state of the SNSPD 2 and thus the measurement result of the SNSPD 2.

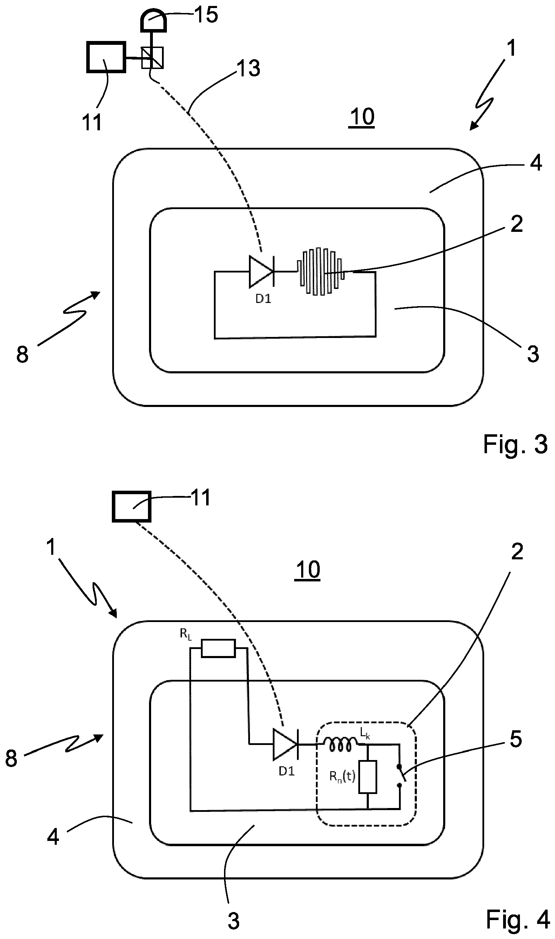

In comparison for example with the embodiment of Figure 4, in the embodiment of Figure 2 all elements can be and are located in the first cooling stage 3 at the lowest cooling temperature in the cryostat system 1. This enables easy and scalable system level integration.

The PVC D1 in the embodiments described is a multijunction structure that can generate the threshold voltage required to power the LED D2 of the embodiments according to Figures 2 and 3. In order to lower the threshold voltage of the LED D2 the band gap of the LED D2 is smaller than the band gap of the PVC D1. In the embodiments described the PVC D1 junction is a GalnP junction and the LED D2 is based on GaAs. In a further embodiment the PVC D1 junction is a GaAs junction and the LED D2 is based on GalnAs.

In the embodiment of Figure 3 excess energy introduced into the first cooling stage is also transferred out of the first cooling stage by electromagnetic radiation. However, the embodiment of Figure 3 instead of providing a separate LED D2 relies on a functionality of the PVC D1 itself. In Figure 3 the SNSPD 2 is drawn schematically instead of providing the full equivalent circuit. As before the PVC D1 acts as a photocurrent generator, since it is operated near its short circuit condition.

The powering electromagnetic radiation illuminating the PVC D1 is reflected by a reflecting layer as part of the PVC D1. In a beam direction of the powering electromagnetic radiation the reflecting layer is placed behind the active layers of the PVC D1. Thus, the powering electromagnetic radiation which hasn't been absorbed in the active layers is reflected. After reflection this radiation becomes dissipating electromagnetic radiation and is coupled back into the fiber 13, which thus is a fiber for the powering electromagnetic radiation as well as for the dissipating electromagnetic radiation.

In the exemplified embodiment of Figure 4 for the transfer of excess power out of the first cooling stage 2 a heat dissipating resistor R_{L} in the second cooling stage 4 is used. This heat dissipating resistor R_{L} replaces the LED D2 of the embodiment of Figure 2 and is the transmitting element in the sense of the present application.

Once the heat dissipating resistor R_{L} is properly selected or controlled, the power conversion efficiency of the PVC D1 is maximized, which in turn results in minimized heat losses in the first cooling stage 3. Heat losses to a large extend are transferred to the second cooling stage 4. Therefore, by using this approach, the thermal heat load in the first cooling stage 3 is reduced by 50 % to 70 %, and the excess energy will be transferred into and remotely dissipated in the second cooling stage 4.

For the purposes of the original disclosure, it is pointed out that all features as they become apparent to a person skilled in the art from the present description, the drawings and the claims, even if they have been specifically described only in connection with certain further features, can be combined both individually and in any desired combinations with other of the features or groups of features disclosed herein, unless this has been expressly excluded or technical circumstances rendersuch combinations impossible or pointless. A comprehensive, explicit description of all conceivable combinations of features is omitted here only for the sake of brevity and readability of the description.

While the invention has been illustrated and described in detail in the drawings and the foregoing description, this illustration and description are merely exemplary and are not intended to limit the scope of protection as defined by the claims. The invention is not limited to the embodiments disclosed.

Variations of the disclosed embodiments will be apparent to those skilled in the art from the drawings, description and appended claims. In the claims, the word "comprising" does not exclude other elements or steps, and the indefinite article "one" or "a" does not exclude a plurality. The mere fact that certain features are claimed in different claims does not exclude their combination. Reference signs in the claims are not intended to limit the scope of protection.

### List of reference numbers

- 1: cryostat system
- 2: superconducting nanowire single-photon detector
- 3: first cooling stage
- 4: second cooling stage
- 5: switch
- 6: DC current source
- 7: load impedance
- 8: cryostat
- 9: cable pair
- 10: ambient environment
- 11: laser
- 13: optical fiber for the powering electromagnetic radiation
- 14: optical fiber for the dissipating electromagnetic radiation
- 15: photodiode

- Lₖ: kinetic inductance
- Rₙ: hotspot resistance
- R_{L}: heat dissipating resistor
- D1: photovoltaic power converter
- D2: light emitting diode

## Claims

1. A method for providing electrical energy to an electronic circuitry (2) located in a first cooling stage (3) of a cryostat system (1) operated at a first cooling temperature, wherein the first cooling temperature is smaller than 273 K, wherein the method comprises the steps
generating and emitting powering electromagnetic radiation at a location outside (10) the first cooling stage (3),
illuminating a photovoltaic power converter (D1) with the powering electromagnetic radiation,
wherein the photovoltaic power converter (D1) is located in the first cooling stage (3), and
wherein the electronic circuitry (2) is electrically connected to the photovoltaic power converter (D1),
generating an electric current in the photovoltaic power converter (D1), and electrically powering or biasing the electronic circuitry (2),
**characterized in that** the method further comprises the step
transmitting excess energy introduced into the first stage by the powering electromagnetic radiation out of the first cooling stage (3) by means at least of dissipating electromagnetic radiation or of the electric current.

2. The method according to the previous claim, wherein the step of transmitting the excess energy comprises
generating the dissipating electromagnetic radiation in a light emitting element (D2) driven by the electric current generated in the photovoltaic power converter (D1), and
emitting the dissipating electromagnetic radiation to a location (10) outside the first cooling stage (3).

3. The method according to any one of the previous claims, wherein the step of transmitting the excess energy comprises
guiding the electric current through an electrical resistor (R_{L}), wherein the electrical resistor (R_{L}) is located outside the first cooling stage (3).

4. The method according to any one of the previous claims, wherein the step of transmitting the excess energy comprises
radiating the dissipating electromagnetic radiation from the photovoltaic power converter (D1) to a location (10) outside the first cooling stage (3).

5. The method according to the previous claim, wherein the step of radiating comprises at least
absorbing the powering electromagnetic radiation in the photovoltaic power converter (D1) and reemitting the dissipating electromagnetic radiation from the photovoltaic power converter (D1) or
reflecting at least part of the powering electromagnetic radiation at the photovoltaic power converter (D1) and radiating the reflected powering electromagnetic radiation as the dissipating electromagnetic radiation.

6. The method according to any one of the previous claims, wherein the method further comprises the steps
detecting the dissipating electromagnetic radiation or the electric current at a location outside the first cooling stage,
generating a detector signal from the dissipating electromagnetic radiation detected or the electric current detected, and
determining a state of the electronic circuitry (2) from the detector signal.

7. A cryostat system (1) comprising
a first cooling stage (3) to be operated at a first cooling temperature,
wherein the first cooling temperature is smaller than 273 K,
an electronic circuitry (2),
a photovoltaic power converter (D1) located in the first cooling stage (3), and
a radiation source (11) located outside the first cooling stage (3),
wherein the radiation source (11) is arranged and located such that during use of the cryostat system (1) powering electromagnetic radiation is emitted by the radiation source (11) and illuminates the photovoltaic power converter (D1),
wherein the electronic circuitry (2) is electrically connected to the photovoltaic power converter (D1) such that during operation of the cryostat system (1) the photovoltaic power converter (D1) powers or biases the electronic circuitry (2),
**characterized in that**
the cryostat system (1) comprises a transmitting element (D2, D1, R_{L}),
wherein the transmitting element (D2, D1, R_{L}) is electrically connected to the photovoltaic power converter (D1) or is the photovoltaic power converter (D1),
wherein the transmitting element (D2, D1, R_{L})
is arranged such that the transmitting element (D2, D1, R_{L}) during operation of the cryostat system (1) transmits excessive energy introduced into the first stage by the powering electromagnetic radiation out of the first stage by means at least of dissipating electromagnetic radiation or of the electric current.

8. The cryostat system (1) according to the previous claim, wherein the transmitting element (D2, D1) is arranged such that the transmitting element (D2, D1) during operation of the cryostat system (1) transmits excessive energy as dissipating electromagnetic radiation, and wherein the cryostat system (1) comprises means for guiding the dissipating electromagnetic radiation out of the first cooling stage (3).

9. The cryostat system (1) according to the previous claim, wherein the transmitting element is a light emitting element (D2) converting the electrical current into the dissipating electromagnetic radiation during operation of the cryostat system (1), preferably is a light emitting diode or a laser diode.

10. The cryostat system (1) according to claim 9, wherein the cryostat system (1) comprises a detector (15) located outside the first cooling stage and a controller, wherein the controller is effectively connected to the detector (15) such that during operation of the cryostat system (1) the controller receives a detector signal from the detector, wherein the detector signal represents a property of the dissipating electromagnetic radiation detected by the detector (15), wherein the detector (15) is arranged and located such that the detector (15) during operation of the cryostat system (1) detects the dissipating electromagnetic radiation emitted by the light emitting element (D2), and wherein the controller is set up to determine a state at least of the electronic circuitry (2) from the detector signal.

11. The cryostat system (1) according to any one of claims 7 to 10, wherein the transmitting element is arranged such that the transmitting element (R_{L}) during operation of the cryostat system (1) converts electrical energy into heat and is located outside the first cooling stage (3).

12. The cryostat system (1) according to any one of claims 7 to 11, wherein the photovoltaic power converter (D1) is the transmitting element (D1), wherein the photovoltaic power converter (D1) is arranged such that during operation of the cryostat system (1) the photovoltaic power converter (D1) radiates the dissipating electromagnetic radiation to a location outside the first cooling stage (3).

13. The cryostat system (1) according to any one of claims 7 to 12, wherein the cryostat system (1) comprises a second cooling stage at a second cooling temperature, wherein the second cooling temperature is smaller than 273 K and is larger than the first cooling temperature, and wherein the photovoltaic power converter (D1) is located in the first cooling stage and the transmitting element is located in the second cooling stage (4).

14. The cryostat system (1) according any one of the previous claims, wherein the electronic circuitry is a superconducting sensor (2), preferably a superconducting nanowire single-photon detector or the electronic circuitry is a superconducting actuator.

15. The cryostat system (1) according any one of the previous claims, wherein the electronic circuitry is part of a quantum computer.
